Europäisches Patentamt

European Patent Office

Office européen des brevets

(19)

(11) Veröffentlichungsnummer: **0 019 129
B1**

(12) **EUROPÄISCHE PATENTSCHRIFT**

(45) Veröffentlichungstag der Patentschrift: **18.09.85**

(51) Int. Cl.⁴: **H 03 M 1/24**

(21) Anmeldenummer: **80102282.3**

(22) Anmeldetag: **28.04.80**

(54) **Einrichtung zur Stellungsdetektion insbesondere zur Winkelstellungsdetektion.**

(30) Priorität: **16.05.79 CH 4537/79**

(43) Veröffentlichungstag der Anmeldung:
**26.11.80 Patentblatt 80/24**

(45) Bekanntmachung des Hinweises auf die
Patenterteilung:
**18.09.85 Patentblatt 85/38**

(84) Benannte Vertragsstaaten:
**DE FR GB IT**

(56) Entgegenhaltungen:
**DE-A-2 041 832
FR-A-2 128 699**

(73) Patentinhaber: **SSIH Equipment S.A.
96, Rue Stämpfli
CH-2500 Bienne (CH)**

(72) Erfinder: **Spälti, Max
Bellikerstrasse 28
CH-8968 Mutschellen (CH)**
Erfinder: **Vanek, Vladimir
Weihermattstrasse 71
CH-8902 Urdorf (CH)**

(74) Vertreter: **Fillinger, Peter, Dr.
Rütistrasse 1a
CH-5400 Baden (CH)**

Courier Press, Leamington Spa, England.

**Beschreibung**

Die vorliegende Erfindung bezieht sich auf eine Einrichtung zur Stellungsdetektion eines Markierungströgers mit parallel Markierungsreihen, insbesondere zur Winkelstellungsdetektion eines um eine Achse drehbaren Markierungsträgers mit zur Achse konzentrischen Markierungsreihen, die je einer Binärstelle eines kodierten Stellungssignals zugeordnet sind, denen je ein von einer Zeitfolgeschaltung betätigter Lichsignalgeber sowie ein gemeinsamer Lichtsignalempfänger zugeordnet ist, wobei die Lichtsignalgeber und der Lichtsignalempfänger durch einen von den Markierungen des Trägers steuerbaren Signalübertragungskanal verbunden sind, mit Mitteln zur Erzeugung eines Markierungssignals für die Zuordnung der Uebertragungstakte zu den Markierungsreihen und mit einer Ausblendeeinrichtung zur Unterdrückung verstümmelter Signale.

Einrichtung zur Stellungsdetektion der vorgenannten Art mit scheibenförmigem Markierungsträger und konzentrischen Markierungsreihen sind allgemein bekannt (z.B. Steinbuch, "Taschenbuch der Nachrichtenverarbeitung" Springer-Verlag, 1962, Seite 761). Die Markierungen sind hier durch elektrisch leitende Spurabschnitte gegeben, wobei eine Sprungquelle als gemeinsamer Signalgeber sowie den einzelnen Markierungsreihen bzw. -spuren zugeordnete Schleifkontakte mit je einer zugehörigen Signalleitung als Signalübertragungskanal und für jede Markierungsreihe ein eigener Signalempfänger, beispielsweise ein Relais oder dgl., vorgesehen ist. Es handelt sich also um eine Parallelabtastung mit parallel geschaltetem Empfängervielfach, an desen Ausgängen das kodierte Stellungssignal mit seinen Binärstellen in Paralleldarstellung erscheint. Falls eine Umsetzung in eine serielle Signalform erwünscht ist, so wird hierfür ein entsprechender Umsetzer nachgeschaltet.

Eine solche Stellungdetektion mit Parallelabtastung von Markierungsreihen erfodert einen vergleichsweise hohen Schaltungsaufwand infolge des Empfängervielfachs und der ggf. erforderlichen Parallel-Serienumsetzung der Abtastsignale.

Durch die DE-PS 20 41 832 wurde eine Einrichtung der eingangs erwähnten Art offenbart. Diese vorbekannte Einrichtung hat den Nachteil, dass sie raumbeanspruchend in dem Sinne ist, dass sie in Richtung der Drehachse des Markierungsträgers gesehen nicht flach ausgeführt werden kann, was insbesondere bei deren Verwendung in Anzeigetafeln für wechselnde Anzeigen, wie z.B. Zugsabfahrtszeiten nachteilig ist. Ebensowenig offenbart diese Druckschrift, wie bei einer derartigen Kleinbauweise der Einrichtung eine Unterdrückung verstümmelter Signale erreicht werden kann. Hierzu gibt auch die F-PS 21 28 699 keine Anregung obwohl sie eine Ausblendespur trägt, die aber nicht in Funktionsverbindung mit den Mitteln für ein Markierungssignal steht.

Ausgehend von dieser Sachlage stellt sich die vorliegende Erfindung die Aufgabe, eine Vorrichtung gemäss der DE-PS 20 41 832 derart zu verbessern, dass sie in äs011erst kleiner, insbesondere flacher Bauweise ausführbar ist.

Erfindungsgemäss wird diese Aufgabe dadurch gelöst, dass die Lichtsignalgeber und der Lichtsignalempfänger auf der gleichen Seite des Markierungsträgers angeordnet sind und dass der auf der gegenüberliegenden Seite des Markierungsträgers liegende Teil des Signalübertragungskanals als flacher Lichtleiterkörper ausgebildet ist.

Nach einer bevorzugten Ausführungsform kann vorgesehen sein, dass der Körper ein glasklarer thermoplastischer Körper ist, der sich vom Signalempfänger weg gegen die Lichtsignalgeber in einzelne Aeste aufteilt. Hierdurch wird nicht nur eine flache Bauweise der Einrichtung sondern zusätzlich eine einfache Montage begünstigt.

Zur Erzielung einer hohen Anzeigesicherheit bei geringem Schaltungsaufwand kann vorgesehen sein, dass die Ausblendeinrichtung eine auf dem Markierungsträger konzentrisch angeordnete weitere Markierungsreihe sowie einen auf den gemeinsamen Signalempfänger wirkenden Lichtschalter aufweist, und dass diese Ausblendungsmarkierungen eine Erstreckung in Bewegungsrichtung des Trägers aufweisen, die geringer ist als die kürzeste jeweils einer Detektionsstellung zugeordnete Erstreckung der Markierungen der Markierungsreihen, und dass das Markierungssignal zusätzlich dem weiteren Lichtsignalgeber als Ausblendsignal zugeleitet wird.

Weitere Merkmale und Vorteile der Erfindung werden anhand des in den Zeichnungen schematisch veranschaulichten Ausführungsbeispiels erläutert. Hierin zeigt:

Fig. 1 ein Systemschaltbild einer Einrichtung zur Stelungsdetektion mit rotierendem Markierungsträger,

Fig. 2 ein Zeit-Signaldiagram zum Wirkungsweise der Einrichtung nach Fig. 1,

Fig. 3 einen Schaltungsplan des elektronischen Teils der Einrichtung nach Fig. 1,

Fig. 4 einen Vertikalschnitt durch einen Winkelstellungsdetektor entsprechend der Linie IV—IV in Fig. 5,

Fig. 5 eine Draufsicht auf Fig. 4 in Richtung des Pfeiles V,

Fig. 6 eine gleiche Ansicht wie Fig. 5, wobei die Lichtleiter weggelassen sind,

Fig. 7 einen Schnitt längs der Linie VII—VII in Fig. 4,

Fig. 8 einen Schnitt längs der Linie VIII—VIII in Fig. 4,

Fig. 9 eine Ansicht eines Lichtleiters in Richtung des Pfeiles IX in Fig. 5 und

Fig. 10 einen Schnitt längs der Linie X—X in Fig. 9.

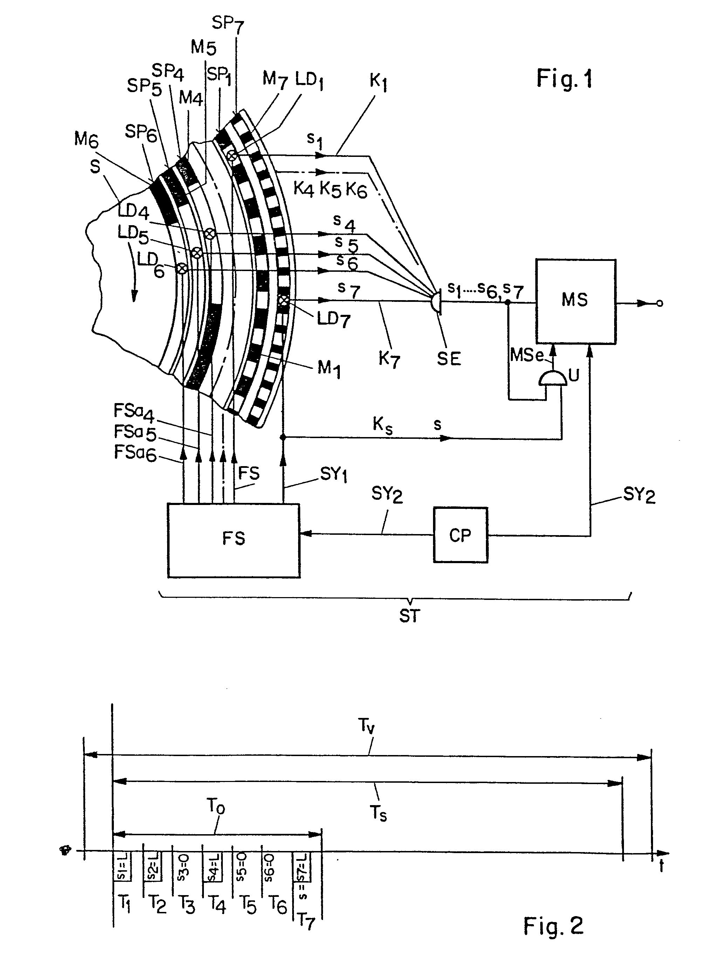

Das in Fig. 1 dargestellte System umfasst einen scheibenförmigen, in Pfeilrichtung rotierenden Markierungsträger S mit beispielsweise sechs Markierungsreihen in Form von konzentrischen Spuren $SP_1$ ... $SP_6$, deren Markierungen $M_1$ ... $M_6$ entsprechend der unterschiedlichen Signifikanz innerhalb des gewählten Codes, hier etwa eines einfachen Dualzahlcodes, unterschiedliche Längenerstreckung in Scheibenumfangsrichtung aufweisen. Im Beispielsfall ist eine Abtastung und Signalübertragung mit elektromagnetischer Srahlung im sichtbaren Wellenlängenbereich oder in benachbarten Wellenlängenbereichen angenommen, speziell eine solche mit Infrarotlicht. Demgemäss ist für jede der Spuren $S_1$ ... $SP_6$ ein Licht-Signalgeber in Form einer Leuchtdiode $LD_1$...$LD_6$ vorgesehen. Die Markierungen $M_1$...$M_6$ der Spuren, welche jeweils einen der betreffenden Spur zugeordneten, optischen Signalübertragungskanal $K_1$...$K_6$ aktivieren, also beispielsweise als das Licht durchlassende Aussparungen oder dieses reflektierende Belagsabschnitte des Träger ausgebildet sind, unterscheiden sich in der Darstellung in Fig. 1 durch ihre Schwärzung von den dazwischen angeordneten, das Licht sperrenden und die entsprechenden Signalübertragungskanäle inaktivierenden Spurabschnitten.

Die Leuchtdioden $LD_1$...$LD_6$ werden in zeitlicher Aufeinanderfolge von zugeordneten Steuerausgängen $FSa_1$...$FSa_6$ einer Zeitfolgeschaltung FS aktiviert, welch letztere zusammen mit einem Synchron-Taktgeber CP und einem Markierungsschalter MS Bestandteil einer Steuerschaltung ST für die codierungsund stellengerechte Zuordnung der Abtastsignale zu den Markierungsreihen ist. Die optischen Signalübertragungskanäle $K_1$...$K_6$ sind ausgangsseitig mit einem gemeinsamen, optischen Signalempfänger SE gekoppelt beispielsweise einer Fotozelle, einem Fototransistor oder einer Fotodiode, dessen Ausgangssignal seriell, d.h. in zeitlicher Aufeinanderfolge Abtastsignale $s_1$...$s_6$ in Zuordnung zu den Spuren $SP_1$...$SP_6$ umfasst. Dem nachgeordneten Markierungsschalter MS fällt grundsätzlich die Aufgabe zu, innerhalb der Aufeinanderfolge der Abtastsignale eine eindeutige Zuordnung zu den Markierungsreihen bzw. zu den Binärstellen des codierten Stellungssignals herzustellen. Dies erfolgt im Beispielsfall über einen zusätzlichen, elektrischen Signalübertragungskanal $K_s$ der an einen zusätzlichen, in die Schaltaufeinanderfolge definiert eingefügten Steuerausgang $SY_1$ der Zeitfolgeschaltung FS angeschlossen ist und beispielsweise innerhalb je eines Abtast- bzw. Uebertragungszyklus entsprechend der periodischen Arbeitsweise der Zeitfolgeschaltung FS ein Markierungssignal s zur Markierungsschaltung MS überträgt. Zeitfolgeschalter und Markierungsschalter sind ausserdem vom bereits erwähnten Synchron-Taktgeber CP über entsprechende Signalkanäle $SY_2$ synchronisiert.

In Fig. 2 ist ein Abtast- und Signalübertragungszyklus mit der Periodendauer $T_o$ angedeutet, der sieben Abtast-Zeittakte $T_1$...$T_7$ für die Abtastsignale $s_1$...$s_6$ und jeweils an letzter Stelle innerhalb eines Zyklus für das Markierungssignal s umfasst. Das dargestellte Beispiel entspricht einem Stellungssignal mit den Binärwerten LLO-LOO für die Abtastsignale $s_1$...$s_6$. Das an einer definierten Stelle, nämlich hier in der letzten Stelle eines Zyklus, angeordnete Markierungssignal s erlaubt im Markierungsschalter MS die Zuordnung je einer Folge von sechs Abtastsignalen zu einem sechsstelligen, binär codierten Stellungssignal.

Zusätzlich ist im Beispiel gemäss Fig. 1 eine Ausblendungs-Markierungsreihe als zusätzliche Spur $SP_7$ mit entsprechenden Markierungen $M_7$ vorgesehen. Die Erstreckung diesser Markierungen $M_7$ ist in Scheibenumfangsrichtung jeweils geringer als die kürzeste jeweils einer Detektionsstellung zugeordnete Erstreckung einer der Markierungen $M_1$...$M_6$ für die Erzeugung des codierten Stellungsignals bemessen ist. Dieser Ausblendungsspur ist ein eigener Signalgeber $LD_7$ zugeordnet, der ebenfalls vom Steuerausgang $SY_1$ der Zeitfolgeschaltung FS aktiviert wird und somit jeweils im Takt $T_7$ ein Ausblendungssignal $S_7$ in zeitlicher Uebereinstimmung mit dem Markierungssignal s führt, sofern der zugehörge, optische Signalübertragungskanal $K_7$ durch eine Markierung $M_7$ aktiviert ist. Der Markierungs-Steuereingang MSe des Markierungsschalters MS ist über ein UND-GATTER U mit dem Ausgang des gemeinsamen Signalempfängers SE und dem Ausgang $SY_1$ der Zeitfolgeschaltung FS gekoppelt, so dass die Markierung einer Abtastsignalsfolge nur dann vorgenommen wird, wenn diese innerhalb eines Ausblendungsintervalls entsprechend der Längenerstreckung einer Markierung $M_7$ gemäss der jeweiligen Bewegungsgeschwindigkeit des Trägers liegt. Ein solches Ausblendungsintervall $T_s$ ist in Fig. 2 angedeutet. Die Maximalgeschwindigkeit des Trägers ist so gewählt, dass dieses Intervall jedenfalls immer ein Mehrfaches der Abtast-Periodendauer $T_o$ beträgt. Anderseits ist das Ausblendungsintervall $T_s$ infolge der Abmessung einer Markierung $M_7$ kürzer als das Zeitintervall $T_v$, welches entsprechend der Trägergeschwindigkeit dem Durchlauf der kürzesten Stellungsmarkierung, hier also einer Markierung $M_1$...$M_6$, am zugehörigen Signalgeber $LD_1$...$LD_6$ beträgt. Dadurch werden verstümmelte Abtastsignale im Uebergangsbereich zwischen den Markierungen von der Uebertragung ausgeschlossen.

Es versteht sich, dass die stellenrichtige Markierung der Abtastsignalzyklen durch Uebertragung eines beseonderen Markierungssignals von definierter Lage innerhalb des Abtastzyklus einerseits und die Ausblendung von Abtastzyklen in Abhängigkeit von der Trägerstellung bezüglich eines Signalgebers zwecks Unterrückung von Uebergangsbereichen mit unsicherer oder unverständiger Signalgabe anderseits grundsätzlich zwei voneinander unabhängige Funktionen darstellen. Die im Beispiel nach Fig. 1 gezeigte Kopplung beider Funktionen durch parallele Uebertragung eines Markierungssignals einmal über den Signalgeber $LD_7$ mit nachfolgendem,

optischen Uebertragungskanal $K_7$ und zugehöriger Ausblendungs-Markierungsreihe $SP_7$ und zum anderen unmittelbar über einen elektrischen Synchronisierungskanal $K_s$ mit anschliessender Ueberlagerung beider Signalkanäle durch das UND-gatter U stellt jedoch eine vorteilhaft einfache Lösung dar. Das resultierende, durch die UND-Verknüpfung erhaltene Markierungssignal am Eingang MSe des Markierungsschalters hat dann die zweifache Funktion der stellenrichtigen Signalzuordnung einerseits und der Annullierung eines Abtastsignalzyklus infolge Blockierung des Markierungssignals beim Abblenden des über den Kanal $K_7$ übertrogenen Signals $s_7$.

Weiterhin versteht es sich, dass die Markierung der Abtastzyklen grundsätzlich durch beliebige Kennzeichnung einer vorgegebenen Zeitlage innerhalb eines jeden Abtastzyklus erreicht werden kann. Zwar hat auch hier die gezeigte Lösung mit einem zusätzlichen, elektrischen Synchronisierkanal $K_s$ und entsprechendem, in die Taktfolge der Abtastung eingefügten Markierungssignal s den Vorteil der Einfachheit, jedoch kann beispielsweise eine Markierung auch durch Einprägen einer unterscheidbaren Struktur bei einem der Abtastsignale selbst erreicht werden. Dies ist jedoch im allgemeinen mit erhöhtem Aufwand an Abtast-Taktzeit bzw. Auflösungsvermögen und höherem Gestaltungsaufwand verbunden.

Endlich ist darauf hinzuweisen, dass eine Synchronsteuerung der Zeitfolgeschaltung FS einerseits und des Markierungschalters MS anderseits durch einen gemeinsamen Taktgeber CP mit entsprechenden Synchronisierkanälen $SY_2$ nicht unbedingt erfoderlich ist. Vielmehr kommt grundsätzlich auf der Empfangsseite ein freilaufender Betrieb mit alleiniger Steuerung des Markierungsschalters durch die Ausgangssignale des gemeinsamen Signalempfängers in Verbindung mit einer geeigneten Zyklusmarkierung in Betracht, jedoch ohne Sychronsteuerung des Markierungsschalters entsprechend den einzelnen Takten innerhalb eines jeden Abtastzyklus.

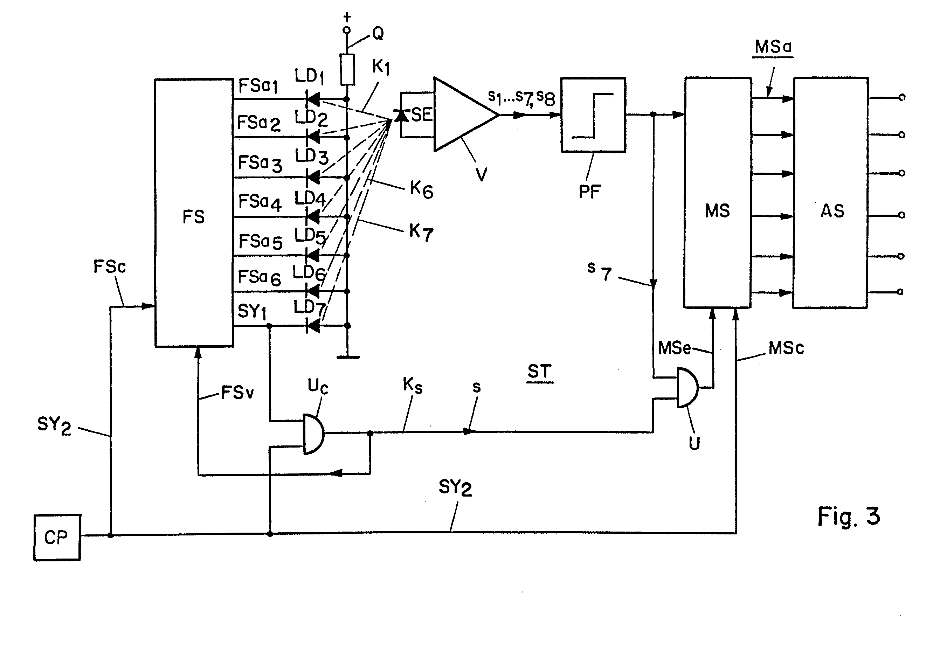

In der Schaltung nach Fig. 3 ist der Anschluss der Signalgeber-Leuchtdioden $LD_1$...$LD_6$ und $LD_7$ an zugehörige Taktausgänge $FSa_1$...$FSa_6$ und $SY_1$ eines üblichen Binärzählers als Zepfolgeschaltung FS einerseits und an eine gemeinsame Speisequelle Q anderseits angedeutet. Die optischen Signalübertragungskanäle $K_1$...$K_6$ und $K_7$ zu einer beispielsweise als gemeinsamer Signalempfänger SE vorgesehenen Fotodiode sind strichliert angedeutet. Es folgt ein Verstärker V ein Impulsformer PF an sich üblicher Art zur Aufbereitung der Abtastsignale $s_1$...$s_6$ und des Ausblendungssignals $s_7$. Der nachfolgende Markieurungsschalter MS kann als an sich übliches Schieberegister mit Schiebe-Takteingang MSc und parallelem Ausgangsvielfach MSa zur Uebergabe des Registerinhaltes in einen Parallel-Ausgangsspeicher AS ausgebildet sein. Diese Uebergabe erfolt durch die bereits erläuterte Verknüpfung von Ausblendungssignal $s_7$ und Markierungssignal s

vom Ausgang der Und-Schaltung U zum Steuereingang MSe des Markierungsschalters, wobei die Uebergabe in den Ausgangsspeicher gleichzeitig die Markierung eines Abtastzyklus und damit eines sechsstelligen binären Stellungssignals bedeutet. Die Verwendung eines Schieberegisters mit Parallel-Ausgangsvielfach und entsprechendem Ausgangsspeicher bedeutet im Beispielsfall einen abschliessenden Uebergang von der seriellen zur parallelen Erscheinungsform der Stellungssignale. Dies ist jedoch kein grundsätzliches Erfordernis, sondern nur eine zusätzlich mögliche Variante.

Das Einschieben der Abtastsignale in das Register des Markierungsschalters MS erfolgt synchron zur Taktung das Zählers der Zeitfolgeschaltung FS von dem gemeinsamen Sychron-Taktgeber CP aus über die bereits erwähnten Kanäle $SY_2$, die an einen Takteingang FSc der Zeitfolgeschaltung einerseits und an den bereits erwähnten Eingang MSc des Markierungsschalters angeschlossen sind. Ferner ist auch das Auftreten des Markierungssignals s im Kanal $K_s$ mittels einer weiteren Und-Schaltung Uc mit der Taktung des Zählers und des Schieberegisters synchronisiert. Dazu ist ein Eingang dieser Und-Schaltung an den Ausgang $SY_1$ der Zeitfolgeschaltung angeschlossen.

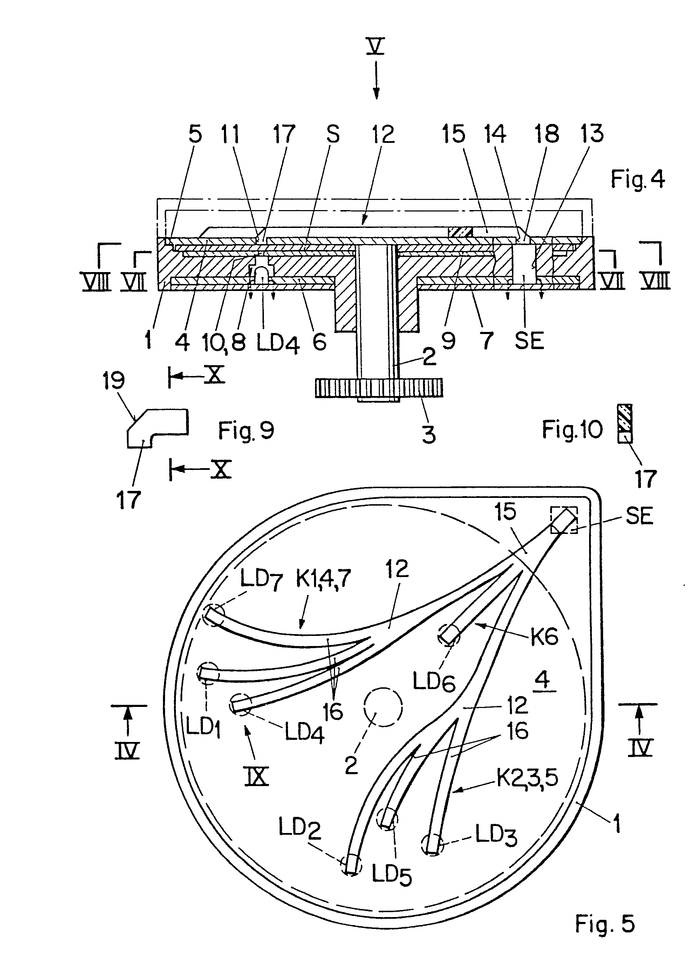

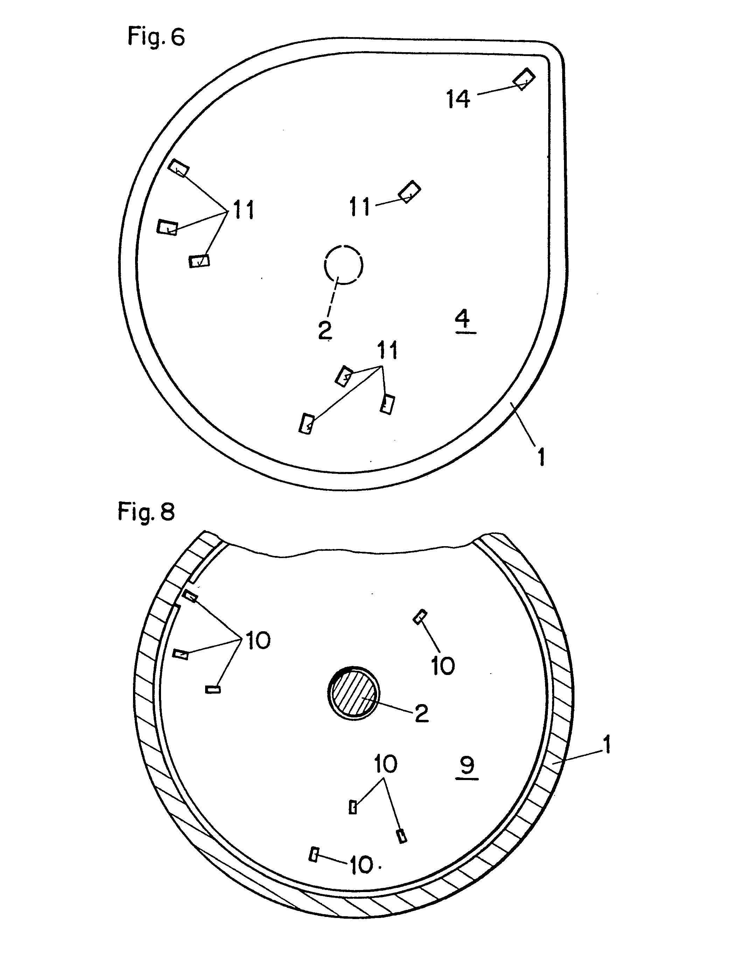

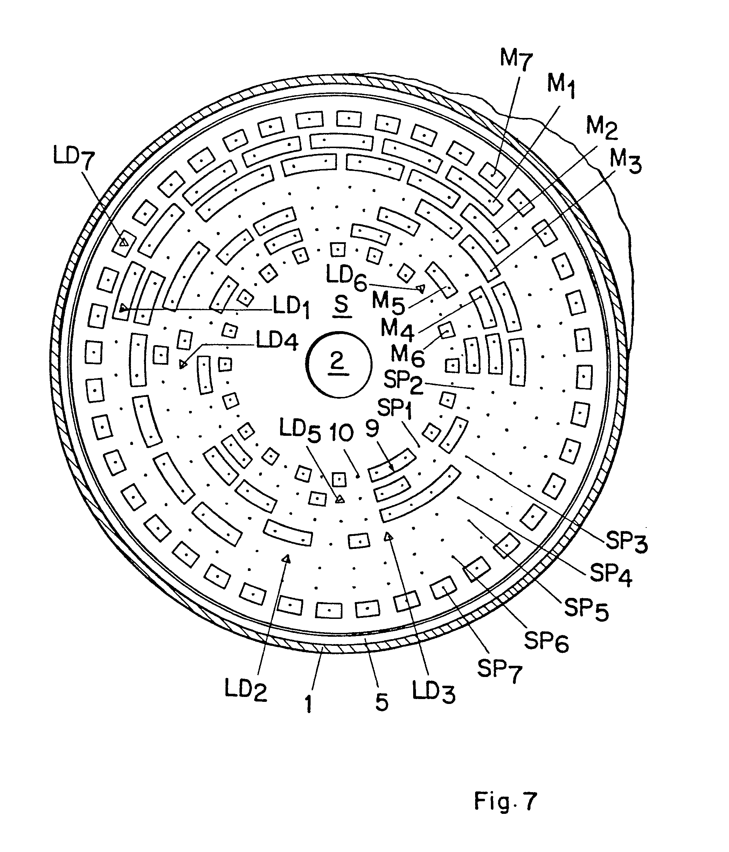

Der Stellungsdetektor weist, wie die Fig. 4 bis 7 zeigen, eine Trägerplatte 1 auf, in der eine Welle 2 mit einem Antriebsritzel 3 drehbar gelagert ist. Das Antriebsritzel 3 steht mit einem nicht dargestellten Motor in getrieblicher Verbindung. Auf das obere Ende der Antriebswelle 2 ist drehfest ein kreisscheibenförmiger Markierungsträger S aufgesetzt, welcher sechs Markierungsreihen $SP_1$...$SP_6$ und eine Ausblendungsspur $SP_7$ aufweist, die konzentrisch zur Drehachse der Welle 2 angeordnet sind (Fig. 7). Bei drehender Welle 2 dreht sich der Markierungsträger S mit. Der Markierungsträger S ist mit einer Platte 4 abgedeckt, die mit nur geringem Abstand darüberliegt und mit ihrer Peripherie auf einer Schulter 5 der Trägerplatte 1 gelagert ist.

Der Markierungsträger S weist auf seinen konzentrischen Spuren $SP_1$...$SP_7$ durchlässige Markierungen $M_1$...$M_7$ in Form von Aussparungen neben undurchlässigen Abschnitten auf. Jeder Spur $SP_1$...$SP_7$ ist eine der Leuchtdioden $LD_1$...$LD_7$, welche vorzugsweise im Infrarotbereich arbeiten, zugeordnet. Wie aus Fig. 4 ersichtlich ist, sind die Leuchtdioden $LD_1$...$LD_7$ in einem plattenförmigen Diodenträger 6 befestigt, und an eine anliegende Printplatte 7 angeschlossen, Konzentrisch zu jeder Leuchtdiode $LD_1$...$LD_7$ ist in der Trägerplatte 1 je eine durchgehende Bohrung 8 vorgesehen, durch welche die Leuchtdioden $LD_1$...$LD_7$ die entsprechende Spur $SP_1$...$SP_7$ des Markierungträgers anbzw. dirchstrahlen kann. Zwischen den oberen Mündungen der Bohrungen 8 einerseits und dem Markierungsträger S anderseits ist in der Trägerplatte 1 eine scheibenförmige Blende 9 angeordnet, die eine ässerst geringe Distanz zum Markierungsträger S aufweist und den Leucht-

dioden LD$_1$...LD$_7$ zugeordnet je eine Blenden-öffnung 10 besitzt. Der Querschnitt der Blendenöffnung 10 ist vorzugsweise wesentliche kleiner als der Querschnitt der kleinsten durchlässigen Markierung M$_1$...M$_7$ im Markierungsträger S.

Die Platte 4 weist jeder Blendenöffnung 10 zugeordnet eine Durchtrittsöffnung 11 für einen Lichtleiter 12 auf. Im Diodenträger 6 und an die Printplatte 7 angeschlossen ist weiter der Empfänger SE, der durch eine Bohrung 13 bis an den Zapfen 18 des Lichtleiters 12 heranreicht. In der axialen Verlängerung der Bohrung 13 ist die Platte 4 mit einer Durchtrittsöffnung 14 für den Lichtleiter 12 versehen. Wie die Fig. 9+10 zeigen, weist der Lichtleiter 12 einen rechteckigen Querschnitt auf und ist mit verschiedenen Aesten 16 versehen (Fig. 5), die in einem Stamm 15 zusammengefasst sind. Am Ende der Aeste 16 sowie am Ende des Stammes 15 ist der Lichtleiter 12 mit nach unten wegragenden Zapfen 17 bzw. 18 versehen, die mit Passsitz in die Durchtrittsöffnungen 11 bzw. 14 greifen. Der Lichtleiter 12 weist über den Zapfen 17 bzw. 18 Umlenkflächen 19 auf welche die von den Leuchtdioden LD$_1$...LD$_7$ ausgesandten Strahlen in Richtung des Lichtleiters 12 und zum Empfänger SE lenken. Der Verlauf der einzelnen Aeste 16 des Lichtleiters 12 ist so zu wählen, dass auf die Wand des Lichtleiters 12 auftreffendes Licht in diesen zurückgelenkt wird. Der Lichtleiter 12 besteht vorzugs-weise aus glasklarem Polystyrol. Die Bohrungen 8, die Blendenöffnungen 10, die Durchtritts-öfnungen 11 und 14 sowie der Lichtleiter 12 bilden Signalübertragungskanäle K$_1$...K$_7$ zwis-chen den Dioden LD$_1$...LD$_7$ und dem Empfänger 19, welche Signalübertragungskanäle auf der Diodenseite des Markierungsträgers S gegenseitig getrennt sind.

Wie aus Fig. 7 hervorgeht, sind die Dioden LD$_1$...LD$_7$ nicht auf einem Radius des Markierungsträgers S angeordnet, sondern zur Erreichung einer kompakten Bauausführung in Umgangsrichtung gegeneinander versetzt. Dabei werden vorzugsweise die einzelnen Spuren SP$_1$...SP$_7$ in Bewegungsrichtung des Markierungsträgers 4 räumlich versetzt. Durch die Steuerschaltung ST werden die einzelnen Leucht-dioden LD$_1$...LD$_7$ nacheinander wie beschrieben aktiviert und die Signalubertragungskanäle K$_1$...K$_7$ durch die Markierungen M$_1$...M$_7$ ges-teuert. Indessen ist es auch möglich, die Dioden, wenn die Baugrösse unkritisch ist, auf einem einzigen Radius des Markierungsträgers S anzu-ordnen.

| | |
|---|---|
| AS | Ausgangsspeicher |
| CP | Synchrontaktgebar |
| FS | Zeitfolgeschaltung |
| FSa$_1$...FSa$_6$ | Steuerausgänge |
| FSc | Takteingang |
| K$_1$...K$_6$ | Signalübertrangskanal |
| K$_7$ | Signalübertragungskanal |
| Ks | Signalübertragungskanal |
| LD$_1$...LD$_6$ | Leuchtdiode/Signalgeber |
| LD$_7$ | Signalgeber |
| M$_1$...M$_6$ | Markierungen/Aussparungen /reflektierende Belags-abschnitte |
| M$_7$ | Markierungen |
| MS | Markierungsschalter |
| MS$_a$ | Ausgangsvielfach |
| MS$_c$ | Schiebetakteingang |
| MS$_e$ | Markierungssteuereingang |
| PF | Impulsformer |
| Q | Speisequelle |
| S | Markierungträger |
| SE | Signalempfänger |
| SP$_1$...SP$_6$ | Markierungsreihe/Spur |
| SP$_2$ | Ausblendungsspur |
| ST | Steuerschaltung |
| SY$_1$ | Steuerausgang |
| SY$_1$ | Signalkanal |
| s | Markierungssignal |
| s$_1$...s$_6$ | Abtastsignale |
| s$_7$ | Ausblendungssignal |
| T$_o$ | Periodendauer |
| T$_1$...T$_7$ | Abtastzeittakte |
| T$_s$ | Ausblendungsintervall |
| T$_v$ | Zeitintervall |
| U | Und-Gatter |
| U$_c$ | Und-Schaltung |
| V | Verstärker |

1 Trägerplatte
2 Welle
3 Antriebsritzel
4 Platte
5 Schulter
6 Diodenträger
7 Printplatte
8 Bohrung
9 Blende
10 Blendenöffnung
11 Durchtrittsöffnung
12 Lichtleiter
13 Bohrung
14 Durchtrittsöffnung
15 Hammer
16 Aeste
17 Zapfen
18 Zapfen
19 Umlenkfläche

**Patentansprüche**

1. Einrichtung zur Stellungsdetektion eines Markierungsträgers mit parallelen Markierungsreihen, insbesondere zur Winkelstellungdetektion eines um eine Achse drehbaren Markierungsträgers mit zur Achse konzentrischen Markierungsreihen, die je einer Binärstelle eines kodierten Stellungssignals zugeordnet sind, denen je ein von einer Zeitfolgeschaltung betätigter Lichtsignalgeber sowie ein gemeinsamer Lichtsignalempfänger zugeordnet ist, wobei die Lichtsignalgeber und der Lichtsignalempfänger durch einen von den Markierungen des Trägers steuerbaren Signalübertragungskanal verbunden sind, mit Mitteln zur Erzeugung eines Markierungssignals für die Zuordnung der Uebertragungstakte zu den Markierungsreihen und mit einer Ausblendeeinrichtung zur Unterdrückung verstümmelter Signale, dadurch gekennzeichnet, dass die Lichtsignalgeber ($LD_1$...$LD_6$) und der Lichtsignalempfänger (SE) auf den gleichen Seite des Markierungsträgers (S) angeordnet und, und dass der auf der gegenüberliegenden Seite des Markierungsträgers (S) leigende Teil ($K_1$, $K_6$) des Signalübertragungskanals als flacher Lichtleiterkörper (12, 15, 16) ausgebildet ist.

2. Einrichtung nach Anspruch 1, dadurch gekennzeichnet, dass der Körper ein glasklarer thermoplastischer Körper ist, der sich vom Signalempfänger (SE) weg gegen die Lichtsignalgeber ($LD_1$...$LD_6$) in einzelne Aeste (16) aufteilt.

3. Einrichtung nach Anspruch 1 oder 2, dadurch gekennzeichnet, dass die Ausblendeinrichtung eine auf dem Markierungsträger konzentrisch angeordnete weitere Markierungsreihe ($SP_7$) sowie einen auf den gemeinsamen Signaleemfänger (SE) wirkenden Lichtsignalgeber ($LD_7$) aufweist, und dass diese Ausblendungsmarkierungen ($M_7$) eine Erstreckung in Bewegungsrichtung des Trägers (S) aufweisen, die geringer ist als die kürzeste jeweils einer Detektionsstellung zugeordnete Erstreckung der Marierungen ($M_1$...$M_6$) der Markierungsreihen ($SP_1$...$SP_6$), und dass das Markierungssignal (s) zusätzlich dem weiteren Lichtsignalgeber ($LD_7$) als Ausblendsignal ($S_7$) zugeleitet wird.

## Revendications

1. Dispositif de détection de la position d'un support de marques, pourvu de repères parallèles, notamment pour la détection de la position angulaire d'un support de marques pouvant tourner autour d'un axe et comportant des séries de marques concentriques à l'axe, qui sont affectées chacune à un bit d'un signal de position codé et à chacune desquelles correspond un émetteur de signaux lumineux activé par un circuit de rythme ainsi qu'un récepteur de signaux lumineux commun, les émetteurs de signaux lumineux et le récepteur de signaux étant reliés, par l'intermediaire d'un canal de transmission de signaux piloté par les marques du support, à des moyens générateurs d'un signal de marquage pour l'attribution des impulsions de transmission aux séries de marques et à un dispositif de masquage pour le blocage de signaux perturbés, caractérisé par le fait que les émetteurs de signaux lumineux ($LD_1$...$LD_6$) et le récepteur de signaux lumineux (SE) sont disposés du même côté du support de marques (S) et en ce que la partie ($K_1$, ...$K_6$) du canal de transmission de signaux située du côté opposé du support de marques est conformée en corps conducteur de lumière plat (12, 15, 16).

2. Dispositif selon la revendication 1, caractérisé par le fait que ledit corps est un corps thermoplastique ayant la transparence du verre, qui se subdivise en branches individuelles (16) depuis le récepteur de signaux (SE) vers les émetteurs de signaux ($LD_1$,...$LD_6$).

3. Dispositif selon la revendication 1 ou 2, caractérisé en ce que le dispositif de masquage présente une autre série de marques ($SP_7$) disposée concentriquement sur le support de marques, ainsi qu'un émetteur de signaux ($LD_7$) agissant sur le récepteur de signaux commun (SE) et en ce que ces marques de masquage ($M_7$) présentent une étendue dans le sens du mouvement du support (8), plus faible que l'étendue la plus courte des marques ($M_1$...$M_6$) affectées chacune à une position de marquage, des séries de marques ($SP_1$...$SP_6$) et en ce que le signal de marquage (S) est appliqué en outre à l'émetteur de signaux lumineux ($LD_7$) supplémentaire, en tant que signal de masquage ($S_7$).

## Claims

1. Device for position detection of a mark carrier with parallel mark rows, especially for angular-position detection of a mark carrier rotatable about an axis and having rows of marks concentric with respect to the axis, these rows of marks being each associated with a bit of a coded position signal, with each of which there is associated a light signal transmitter operated by a time sequence circuit and also a common light signal receiver, and the light signal transmitter and the light signal receiver are connected by a signal transmission channel controllable by the marks of the carrier, with means for producing a mark signal for the association of the transmission pulses with the mark rows, and with a masking device for the suppression of garbled signals, characterised in that the light signal transmitters ($LD_1$...$LD_6$) and the light signal receiver (SE) are arranged at the same side of the mark carrier (S), and that that part ($K_1$...$K_6$) of the signal transmission channel which is situated at the opposite side of the mark carrier (S) is constructed as a flat light conductor element (12, 15, 16).

2. Device according to claim 1, characterized in that the element is a transparent thermoplastic element which divides into individual branches (16) from the signal receiver (SE) towards the light signal transmitters ($LD_1$...$LD_6$).

3. Device according to claim 1 or 2, characterised in that the masking device comprises a further row of marks ($SP_7$) which is arranged concentrically on the mark carrier, and also a light signal transmitter ($LD_7$ acting on the common signal receiver (SE), and that these mask marks ($M_7$) have an extent in the direction of movement of the carrier (S) which is smaller than the shortest extent, associated with a detection position in each case, of the marks ($M_1$...$M_6$) of the rows of marks ($SP_1$...$SP_6$), and that the mark signal (s) is additionally passed to the further light signal transmitter ($LD_7$ as a mask signal ($S_7$).

Fig. 1

Fig. 2

Fig. 3

0 019 129

Fig. 4

Fig. 9

Fig. 10

Fig. 5

**Fig. 6**

**Fig. 8**

Fig. 7